Europäisches Patentamt

European Patent Office

Office européen des brevets

(19)

(11) Publication number: **0 303 311**
**A1**

## (12) EUROPEAN PATENT APPLICATION

(21) Application number: 88201550.6

(51) Int. Cl.⁴: **H01L 39/24**

(22) Date of filing: **18.07.88**

(30) Priority: **29.07.87 NL 8701789**

(43) Date of publication of application:
**15.02.89 Bulletin 89/07**

(84) Designated Contracting States:
**DE ES FR GB IT NL SE**

(71) Applicant: **N.V. Philips' Gloeilampenfabrieken
Groenewoudseweg 1
NL-5621 BA Eindhoven(NL)**

(72) Inventor: **Klomp, Johannes Theodorus**
c/o Int. Octrooibureau B.V. Prof. Holstlaan 6
Nl-5656 AA Eindhoven(NL)
Inventor: **Van de Ven, Adrianus Johannes
Cornelis**
c/o Int. Octrooibureau B.V. Prof. Holstlaan 6
Nl-5656 AA Eindhoven(NL)

(74) Representative: **Pennings, Johannes et al
Internationaal Octrooibureau B.V. Prof.
Holstlaan 6
NL-5656 AA Eindhoven(NL)**

(54) Method of manufacturing an electrically conductive contact.

(57) A mechanically strong and electrically readily conductive connection with an oxidic superconductive material is produced by means of thermocompression in which the oxygen content of the superconductive material is not disturbed.

EP 0 303 311 A1

## Method of manufacturing an electrically conductive contact.

The invention relates to a method of manufacturing an electrically conductive contact with an oxidic superconductive material.

A method of providing electrically conductive contacts on an oxidic superconductive material in which electrodes of gold are vapour deposited which are provided in contact with indium wires is described in an article by J.G. Bednorz and K.A. Müller in Z.Phys.B -Condensed Matter 64, pp 189-193 (1986).

A method in which for the same purpose a silver paste is used is described in an article by P.M. Grant a.o. in Physical Review B, 35 (13), pp. 7242-7244 (1987).

The disadvantage of these known methods is that mechanically strong connections are not obtained. Other known methods of making stronger connections, for example welding, cannot be used because at the high temperature required for this purpose the oxygen content of the superconductive material may be disturbed. For example, in the case of $YBa_2Cu_3O_{7-\delta}$, when heated above a temperature of approximately 500° C loss of oxygen occurs and the crystal structure changes from orthorombic to cubic. When the temperature is decreased, particular precautions are necessary (slow cooling in an oxidizing atmosphere) because otherwise loss or reduction of superconductive properties occurs. Another problem is that at high temperature diffusion of the material to be provided may occur in the superconductive material so that the quantity of oxygen and the valency of the copper ions may be disturbed. This is also at the expense of the superconductive behaviour.

It is the object of the invention to provide a method of manufacturing a mechanically strong and electrically readily conducting connection with an oxidic superconductive material in which the temperature remains so low that the properties important for superconductivity are not disturbed. Another object of the invention is to provide a clean and rapid method with reproducible results.

According to the invention, these objects are achieved by means of a method in which a metal which with respect to oxygen is reactive is mechanically contacted with the superconductive material and is plastically deformed.

During the plastic deformation the metal is heated, the melting point of the material being not reached. The temperature preferably remains below 0.9 $T_m$, wherein $T_m$ is the melting-point of the metal in degrees K. In order to perform the activities at none too high a temperature, a low-melting point metal is used, for example, aluminium, lead, indium or an alloy of aluminium lead or indium.

The method according to the invention (briefly referred to as thermocompression) is particularly suitable for providing electrically conductive connections on $YBa_2Cu_3O_{7-\delta}$, in which the plastic deformation is produced at a temperature below 450° C. $YBa_2Cu_3O_{7-\delta}$, wherein $\delta$ has a value of approximately 0.1 to 0.5, is superconductive at temperatures lower than approximately 90 K.

For the manufacture of the electrically conductive contact, for example, a wire or ribbon may be connected directly to the superconductive material by means of thermocompression. In addition it is also possible to provide a contact plate by means of thermocompression, after which a wire is connected to the contact plate, for example, by means of soldering.

With thermocompression a reaction occurs at the interface between the parts to be connected between the bonding material and the oxygen of the superconductive material. The copper is also reduced locally. However, this is done only in a thin boundary layer around the contact so that on the one hand a strong bonding connection is obtained but on the other hand the superconductive properties of the oxidic material are disturbed only in a small area which adjoins the contact material which is not superconductive as it is.

The method according to the invention is particularly suitable for providing electrically conductive connections on bulk material.

The method according to the invention will now be described in greater detail with reference to an example.

Example.

An aluminium plate is provided on a pill of $YBa_2Cu_3O_{6.7}$ and plastically deformed at 400° C. The exerted pressure is 25 N/mm$^2$ and the pressure is maintained for 2 seconds.

The result is a mechanically strong connection having a low contact resistance.

Claims

1. A method of manufacturing an electrically conductive contact with an oxidic superconductive material, characterized in that a material which is reactive with respect to oxygen is contacted mechanically with the superconductive material and is plastically deformed.

2. A method as claimed in Claim 1, characterized in that the metal is aluminium, lead, indium or an alloy of aluminium, lead or indium.

3. A method as claimed in Claim 1, characterized in that the superconductive material is $YBa_2Cu_3O_{7-\delta}$ and the plastic deformation is produced at a temperature below $450^\circ$ C.

European Patent Office

**EUROPEAN SEARCH REPORT**

Application Number

EP 88 20 1550

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | ADVANCED CERAMIC MATERIALS- CERAMIC SUPER-CONDUCTORS, vol. 2, no. 3B, special issue, July 1987, pages 380-387, AcerS, Westerville, OH, US; Q. ROBINSON et al.: "Sinter-forged YBa2Cu3O7-$\delta$" * Page 381, paragraph 2 * | 1 | H 01 L 39/24 |
| A | ADVANCED CERAMIC MATERIALS- CERAMIC SUPER-CONDUCTORS, vol. 2, no. 3B, special issue, July 1987, pages 364-371, ACerS, Westerville, OH, US; D.W. JOHNSON et al.: "Fabrication of ceramic articles from high Tc superconducting oxides" * Page 365, line 35 * | 1 | |

TECHNICAL FIELDS SEARCHED (Int. Cl.4)

H 01 L 39

The present search report has been drawn up for all claims

| Place of search | Date of completion of the search | Examiner |
|---|---|---|
| THE HAGUE | 08-11-1988 | PELSERS L. |